# EUROPEAN PATENT SPECIFICATION

(11) **EP 4 315 612 B1**
(45) Date of publication and mention of the grant of the patent: **02.12.2026**
(21) Application number: 22715057.0
(22) Date of filing: 15.03.2022
(51) Int. Cl.: G01R 15/18, G01R 19/20, H03M 3/00, G01R 33/00, G01R 33/04

(54) **FLUXGATE CURRENT TRANSDUCER**
FLUXGATE-STROMWANDLER
TRANSDUCTEUR DE COURANT DE BARRIÈRE DE FLUX

(30) Priority: 22.03.2021 EP 21164001
(43) Date of publication of application: 07.02.2024
(73) Proprietor: LEM International SA, 1217 Meyrin (CH)
(72) Inventor: MILLET, Fabien, 74890 Bons-en-Chablais (FR); TROMBERT, Stéphan, 74320 Leschaux (FR)
(74) Representative: reuteler & cie SA
(86) International application number: PCT/EP2022/056763
(87) International publication number: WO 2022/200135

(56) References cited:
- EP-A1- 3 771 915
- US-B2- 9 714 987
- O'BRIEN H ET AL: "A radiation tolerant digital fluxgate magnetometer", MEASUREMENT SCIENCE AND TECHNOLOGY, IOP, BRISTOL, GB, vol. 18, no. 11, November 2007 (2007-11-01), pages 3645 - 3650, XP020129314, ISSN: 0957-0233
- CHEN FANG ET AL: "Dual-Resonator MEMS Magnetometer Based on Self-Clocking Sigma-Delta Modulation", IEEE SENSORS JOURNAL, IEEE SERVICE CENTER, NEW YORK, NY, US, vol. 20, no. 3, 12 October 2019 (2019-10-12), pages 1527 - 1535, XP011767107, ISSN: 1530-437X, [retrieved on 20200117], DOI: 10.1109/JSEN.2019.2947256
- SOUSA F ET AL: "Taking advantage of LVDS input buffers to implement sigma-delta A/D converters in FPGAs", PROCEEDINGS / 2004 IEEE INTERNATIONAL SYMPOSIUM ON CIRCUITS AND SYSTEMS : MAY 23 - 26, 2004, SHERATON VANCOUVER WALL CENTRE HOTEL, VANCOUVER, BRITISH COLUMBIA, CANADA, IEEE OPERATIONS CENTER, PISCATAWAY, NJ, 23 May 2004 (2004-05-23), pages I - 1088, XP010719511, ISBN: 978-0-7803-8251-0
- SEIFERT E ET AL: "Enhancing the dynamic range of analog-to-digital converters by reducing excess noise", COMMUNICATIONS, COMPUTERS AND SIGNAL PROCESSING, 1989. CONFERENCE PROCEEDING., IEEE PACIFIC RIM CONFERENCE ON, IEEE, June 1989 (1989-06-01), pages 574 - 576, XP032131681, DOI: 10.1109/PACRIM.1989.48429

## Description

The present invention relates to a current transducer with a fluxgate detector, in particular a closed loop current transducer with fluxgate detector.

Fluxgate current transducers are well known and used in many current sensing applications. A fluxgate current transducer typically comprises a magnetic field detector having a saturable soft magnetic core 4 surrounded by an excitation coil 6. In many fluxgate transducers, a primary conductor carrying a current to be measured extends through the central passage of the magnetic field detector. In closed-loop transducers, there is a compensation coil magnetically coupled to the magnetic field detector and connected in a feedback circuit to a signal processing circuit, the compensation coil seeking to cancel the magnetic field generated by the primary conductor. Such an arrangement is well known. It is also possible to use the fluxgate in an open-loop manner whereby there is no compensation coil and only a primary conductor carrying the current to be measured. In view of the high sensitivity of fluxgate magnetic field detectors, they are however mainly used in a closed-loop configuration.

A closed loop current transducer with fluxgate detector is described in US10126332. A current transducer with fluxgate detector as described in the aforementioned patent advantageously provides for very accurate measurement of currents or differential currents flowing in one or more primary conductors extending through a central region of the transducer surrounded by the magnetic circuit core. Fluxgate detectors have a high sensitivity and low offset compared to the widely used Hall effect detectors. The electronics required to drive the excitation current for saturation of the magnetic core of the fluxgate detector as well as for driving the compensation current and any ripple compensation current, render such a current transducer more costly and less compact than conventional open loop current transducers with Hall effect detectors.

Typically, in a current transducer of the aforementioned fluxgate type, a microcontroller (digital signal processor DSP) with two cores is typically needed to guarantee sufficiently high performance, one core being used to excite the fluxgate continuously and obtain fluxgate current information in real time, and the other core used to supervise, communicate and perform calculations. The microcontroller who also typically has a 16 bit differential analog-to-digital ADC converter and generates a high resolution pulse width modulation (PWM) signal that works for instance at 10 megahertz. The cost of such a DSP is however quite high and typically requires implementation on a circuit board of a certain size that exceeds what would be strictly required for dedicated use in signal processing functions required by a current transducer with fluxgate detector.

EP3771915A1 discloses a fluxgate current transducer including a fluxgate device comprising a saturable soft magnetic core and an excitation coil, and a processing circuit comprising a control circuit and a voltage generator connected to the control circuit for generating an alternating current in the excitation coil, configured to alternatingly saturate the soft magnetic core. The control circuit is advatageously provided in a field programmable gate array, FPGA.

The publication by Sousa F. et al: "Taking advantage of LVDS input buffers to implement sigma-delta A/D converters in FPGAs", in Proceedings IEEE ISCAS, May 23 - 26, 2004, pages I-1088, XP010719511, ISBN: 978-0-7803-8251-0 teaches the implementation of a sigma-delta A/D converter within an FPGA, with minimal use of external analog components, taking advantage of existing low-voltage differential signaling, LVDS, I/O pads.

The publication by Seifert E. et al: "Enhancing the dynamic range of analog-to-digital converters by reducing excess noise", in Communications, Computers and Signal Processing, 1989, Conference Proceeding, IEEE, June 1989, pages 574-576, XP032131681, DOI: 10.1109/PACRIM.1989.48429 teaches a technique for improving the dynamic range of analog-to-digital converters consisting of summing outputs of several parallel N-bit ADCs to reduce the uncorrelated excess noise introduced by each ADC, so as to increase the number of effective bits of resolution.

It is an object of this invention to provide a current transducer with fluxgate detector that is very accurate, yet that is cost effective to manufacture and to implement.

It is advantageous to provide a current transducer with fluxgate detector that is easily adjusted or calibrated for user requirements.

It is advantageous to provide a current transducer that is very accurate, has low offset, is easy to implement and may be easy configured for different current measurement ranges in a cost effective and reliable manner.

It is advantageous to provide a fluxgate current transducer that is easy to install and operate.

Objects of the invention have been achieved by providing a fluxgate current transducer according to claim 1 and method of operating a fluxgate current transducer according to claim 7.

Disclosed herein is a fluxgate current transducer including a control circuit and a fluxgate measuring device comprising a fluxgate magnetic field detector, the fluxgate magnetic field detector comprising a saturable soft magnetic core surrounded by an excitation coil, the control circuit comprising an excitation coil drive circuit connected to the excitation coil and a controller connected to the excitation coil drive circuit configured to generate an alternating excitation current Ifx to alternatingly saturate the soft magnetic core, characterized in that the controller is in the form of a FPGA (Field Programmable Gate Array) comprising at least one input comprising a 1 bit sigma delta analog-to-digital converter (ADC) connected to the excitation coil to receive a measurement signal output by the excitation coil.

Said at least one input comprises a LVDS (low voltage differential signaling) or comparator input of the FPGA. It may be noted that an LVDS input may also act act as a comparator and that input circuits designated as comparators may also be used in the sigma delta (ΣΔ) modulator circuits of the present invention.

The FPGA comprises a plurality of inputs comprising each a 1 bit sigma delta analog-to-digital converter (ADC), the bit stream output signals of the plurality of 1 bit sigma delta analog-to-digital converters being added before being fed into a digital filter.

In an advantageous embodiment, the 1 bit sigma delta analog-to-digital converter (ADC) comprises a first resistor (R1) connected in series to a first input of the LVDS, a first capacitor (C1) connected between a reference potential and the first input, and a feedback loop from an output of the LVDS and the first input, the feedback loop comprising a 1 bit DAC and second resistor (R2).

In an advantageous embodiment, the FPGA comprises a 1 bit sigma delta digital-to-analog (DAC) output connected to the excitation coil via a RC filter to supply a voltage control signal that is fed into an amplifier of the excitation coil drive circuit to supply the excitation coil of the fluxgate detector with an alternating excitation current.

In an advantageous embodiment, the transducer further comprises a compensation coil and the control circuit comprises a compensation coil drive circuit to supply the compensation coil of the fluxgate measuring device with a compensation current Is seeking to cancel the magnetic field of the primary current Ip, the FPGA comprising a 1 bit sigma delta digital-to-analog (DAC) output connected to the compensation current coil via an RC filter to supply a voltage control signal to the compensation coil drive circuit.

In an advantageous embodiment, the current transducer further comprises a ripple cancellation coil and the control circuit comprises a ripple cancellation coil drive circuit to supply the compensation coil of the fluxgate measuring device with a compensation current Is seeking to cancel the magnetic field of the primary current Ip, the FPGA comprising a 1 bit sigma delta digital-to-analog (DAC) output connected to the ripple current cancellation coil via an RC filter to supply a voltage control signal to the ripple cancellation coil drive circuit.

In an advantageous embodiment, the FPGA comprises an excitation voltage control circuit portion configured to generate an excitation voltage control signal Ve for the excitation coil having a trapezoidal shaped waveform with rounded corners.

In an advantageous embodiment, the FPGA comprises a plurality of inputs comprising each a 1 bit sigma delta analog-to-digital converter (ADC), a 1 bit stream for each ADC being added before input to a digital filter.

In an advantageous embodiment, the preceding claims characterized in that the method includes generating an excitation signal for the excitation coil of the fluxgate magnetic field detector as a trapezoidal shaped waveform with rounded corners. One may view the excitation signal as a substantially rectangular wave with softened rising and falling edges to reduce noise. The method to soften the edges may include replacing the edges by a reduced harmonic waveform like the rising part of a sine wave

In an advantageous embodiment, the trapezoidal waveform is generated using a fluxgate excitation lookup table stored in a memory of the FPGA.

Further objects and advantageous features of the invention will be apparent from the claims, from the detailed description, and annexed drawings, in which:
Figure 1 is a schematic block diagram of a current transducer with fluxgate detector according to an embodiment of the mention;
Figure 2a is a schematic circuit diagram of a portion of an input circuit to a Field Programmable Gate Array (FPGA) of a transducer control circuit according to an embodiment of the invention;
Figure 2b is a figure similar to figure 2a of a variant;
Figure 2c is a figure similar to figure 2b of yet another a variant;
Figure 3a is a schematic graphical representation of plots of a sinusoidal excitation voltage and associated excitation current of an excitation coil driver according to the prior art;
Figure 3b is a schematic graphical representation of plots of a square excitation voltage and associated excitation current of an excitation coil driver according to the prior art;
Figure 4 is a schematic graphical representation of plots of a hybrid excitation voltage according to an embodiment of the invention and associated excitation current signal.

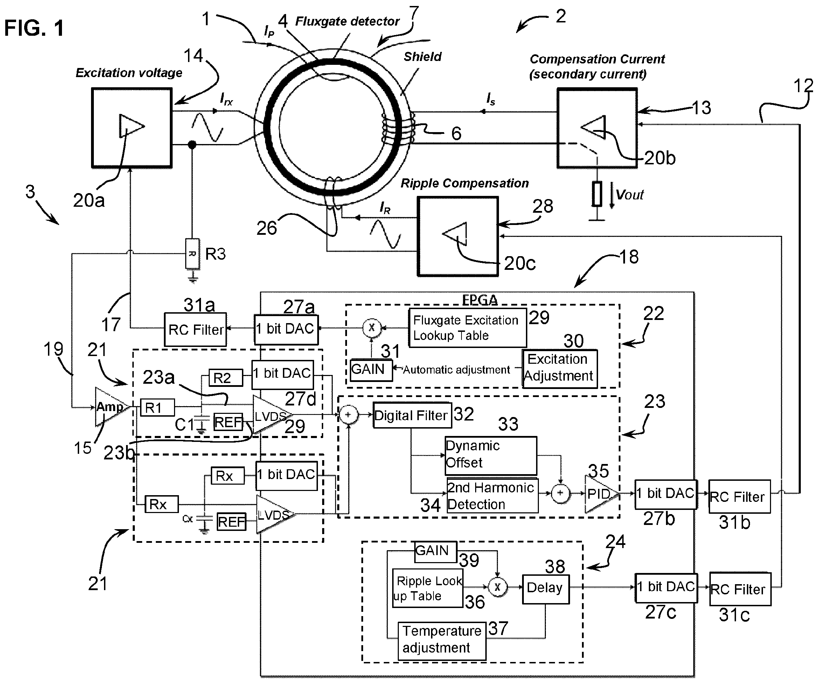

Referring to figure 1, an electrical current transducer 2 for measuring a primary current *I*_{P} flowing in a primary conductor 1 comprises a fluxgate measuring device 7 and a control circuit 3.

The fluxgate measuring device comprises a fluxgate magnetic field detector 4 and a secondary coil 6.

As is *per se* well known in the art, the secondary coil acts as a compensation coil that is supplied with electrical current *I*_{S} in a feedback loop 12 connected to the fluxgate detector 4 that seeks to cancel the magnetic field generated by a primary conductor 1 carrying the current *I*_{P} to be measured, the primary conductor extending through a central passage 10 of the transducer.

The fluxgate magnetic field detector 4 comprises a saturable soft magnetic core surrounded by an excitation coil that is connected to an excitation coil drive circuit 14 that generates an alternating excitation current *I*_{fx} configured to alternatingly saturate the soft magnetic core.

The current transducer may further comprise a ripple compensation circuit 28 connected to a ripple compensation coil 26 to perform a ripple compensating function for instance as *per* se known from WO2016/016038.

The ripple compensation circuit 28 is configured to generate a ripple compensation current *I*_{R} that seeks to cancel the ripple signal caused by the excitation current *I*_{fx} of the fluxgate detector 4.

The excitation voltage signal *I*_{fx} for the excitation coil of the fluxgate magnetic field detector 4 is generated by the control circuit 3, in particular the controller 18 connected to the excitation coil drive circuit 14 which comprises an amplifier 20 to amplify the excitation coil control signal 17 output by the controller 18.

According to a first aspect of the invention, the controller 18 is in the form of a FPGA (Field Programmable Gate Array) comprising at least one LVDS (low voltage differential signaling) input connected to the excitation coil.

The LVDS input forms part of a 1 bit sigma delta analog-to-digital converter (ADC) 21 connected to the excitation coil to receive a measurement signal 19 output by the excitation coil.

In the embodiment illustrated in figure 1, there are two LVDS inputs forming part of two 1 bit sigma delta analog-to-digital converters (ADC) 21 connected to the excitation coil, however the FPGA may comprise only one or more than two LVDS inputs connected to the excitation coil within the scope of the invention. Preferably the FPGA comprises more than two LVDS inputs connected to the excitation coil, for instance 6, 8, or more.

The 1 bit sigma delta analog-to-digital converter (ADC) 21 comprises a first resistor R1 connected in series to a first input 23 of the LVDS, a first capacitor C1 connected between a reference potential (e.g. ground) and the first input 23, and a feedback loop from an output 29 of the LVDS and the first input 23, the feedback loop comprising a 1 bit DAC 27d and second resistor R2. A second input of the LVDS is connected to a reference voltage, for instance a mid-point of the FPGA LVDS bank may be used.

In the input line of the LVDS, the R1-C1 circuit components forms an integrator for the sigma delta conversion, and the amplifier 15 serves to adjust the voltage to the LVDS input and act as a low impedance output and allow the sigma delta conversion to work properly.

Basically, the ADCs 21 comprise an oversampling modulator followed by a digital/decimation filter that together produce a high-resolution data-stream output. The R1-C1 and Rx-Cx circuit components act as integrators and the LVDS inputs act as comparators. The clock frequency of the system (for instance a frequency >100MHz) will then generate a 1 bit stream for each ADC 21 that are added before the digital filter 32. Adding a plurality of 1 bit sigma delta converters 21 increases the resolution of the bit stream and reduces noise.

Advantageously, the 1 bit sigma delta analog-to-digital converter (ADC) 21 configured using a LVDS input of the FPGA is very cost effective to implement yet allows high precision due to the high frequency operational capability of a FPGA LVDS, typically greater than 100MHz, and the digital signal processing of the subsequent measurement signal output by the LVDS. Moreover the 1 bit sigma delta analog-to-digital converter (ADC) 21 configured using a LVDS input 29 of the FPGA exhibits little or no drift and stable measurement accuracy over a typical operating temperature range for fluxgate current transducers.

Another important advantage of the FPGA is that it starts very rapidly, typically in less than 500ms, compared to a DSP which needs about 8 seconds.

The FPGA may advantageously further comprise a 1 bit sigma delta digital-to-analog (DAC) output 27a connected to the excitation coil via a low pass RC filter 31a to supply a voltage control signal that is fed into the amplifier 20 of the excitation coil drive circuit 14 to supply the excitation coil of the fluxgate detector with an alternating excitation current. The FPGA advantageously allows high frequency 1 bit DAC that can be filtered only using first order low pass filters with simple RC circuit components, whereby no active filter is needed.

The fluxgate Excitation LUT (Lookup table) is a table of N points defined that is read at a dedicated frequency to generate the fluxgate excitation signal. Each output value of this table can be adjusted dynamically by a gain circuit 31 and compensated in temperature or other parameters such as magnetic material fluctuations by an excitation adjustment circuit portion 30.

In a variant (not shown), the FPGA may comprise two 1 bit sigma delta digital-to-analog (DAC) outputs 27a to generate a differential output DAC to the excitation coil via low pass RC filters 31a to supply a voltage control signal that is fed into the amplifier 20 of the excitation coil drive circuit 14 to supply the excitation coil of the fluxgate detector with an alternating excitation current.

The FPGA may advantageously further comprise a 1 bit sigma delta digital-to-analog (DAC) output 27b connected to the compensation current coil via a low pass RC filter to supply a voltage control signal that is fed into the amplifier 20b of the compensation coil drive circuit 13 to supply the compensation coil of the transducer device 7 with a compensation current Is seeking to cancel the magnetic field of the primary current *Ip.* ADC inputs are fed into a digital filter 32 to digitalize the fluxgate current thanks to a CIC filter (Cascaded-Integrator-Comb-Filter) and a decimation filter. Then the digitalized fluxgate current is processed to evaluate with a simple calculation the even harmonics of the fluxgate current which should be compensated to perform the regulation.

In a variant (not shown), the FPGA may comprise two 1 bit sigma delta digital-to-analog (DAC) outputs 27b to generate a differential output DAC connected to the compensation current coil via low pass RC filters to supply a voltage control signal that is fed into the amplifier 20b of the compensation coil drive circuit 13.

The FPGA may advantageously further comprise a 1 bit sigma delta digital-to-analog (DAC) output 27c connected to the ripple current cancellation coil 26 via a low pass RC filter 31c to supply a voltage control signal that is fed into the amplifier 20c of the ripple coil drive circuit 28 to supply the ripple current cancellation coil 26 of the transducer device 7 with a ripple coil cancellation current *Ir.*

In a variant (not shown), the FPGA may comprise two 1 bit sigma delta digital-to-analog (DAC) outputs 27c to generate a differential output DAC connected to the ripple current cancellation coil 26 via low pass RC filter 31c to supply a voltage control signal that is fed into the amplifier 20c of the ripple coil drive circuit 28.

The ripple signal generation uses a similar block as described in relation with the excitation signal generation. There is a lookup table that is read at a specific frequency by the FPGA. The output can be adjusted dynamically with a gain circuit portion 39 and compensated in temperature by a temperature adjustment circuit portion 37. To be able to compensate the transducer noise some delay is added by a delay circuit portion 38 to this ripple compensation to compensate the noise properly.

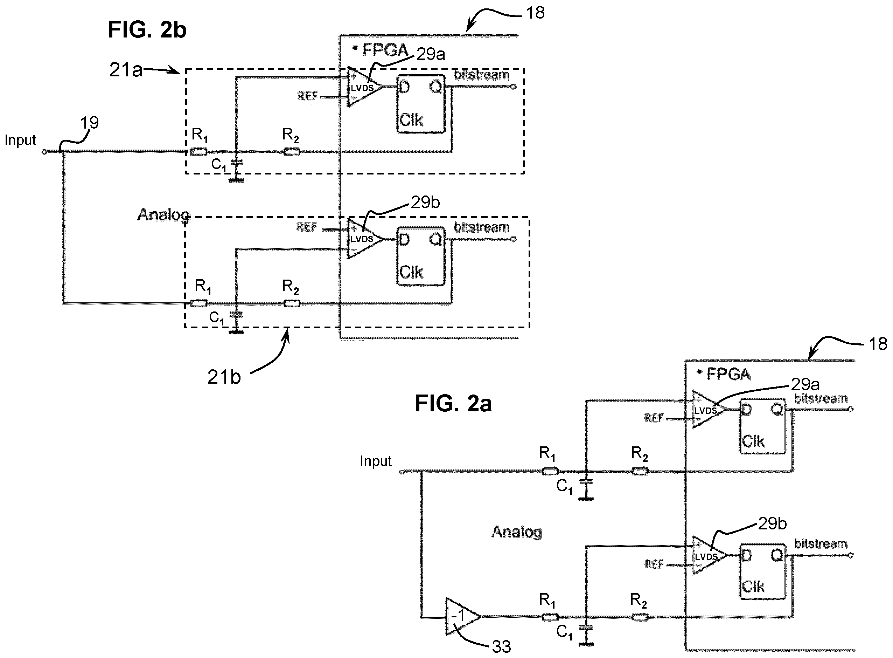

Figures 2a and 2b shows another embodiment of the invention using the 1 bit sigma delta ADC in pseudo differential mode to improve resolution and noise. In Figure 2b, the LVDS input 21b is shifted to get the opposite bitstream of the LVDS input 21a. In Figure 2a, an inverting amplifier 33 is used to avoid inverting the LVDS input to generate the pseudo differential mode.

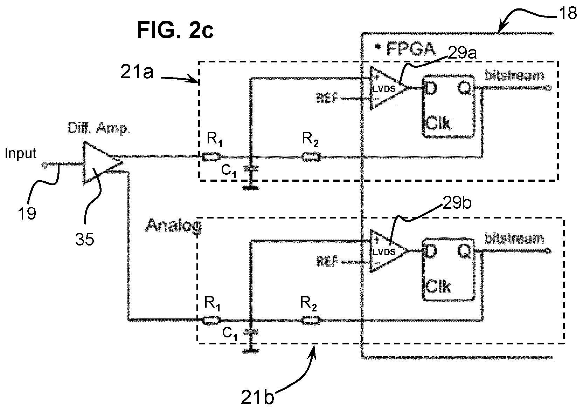

In fig 2C we use a differential amplifier 35 comprising two outputs used to generate the pseudo differential mode.

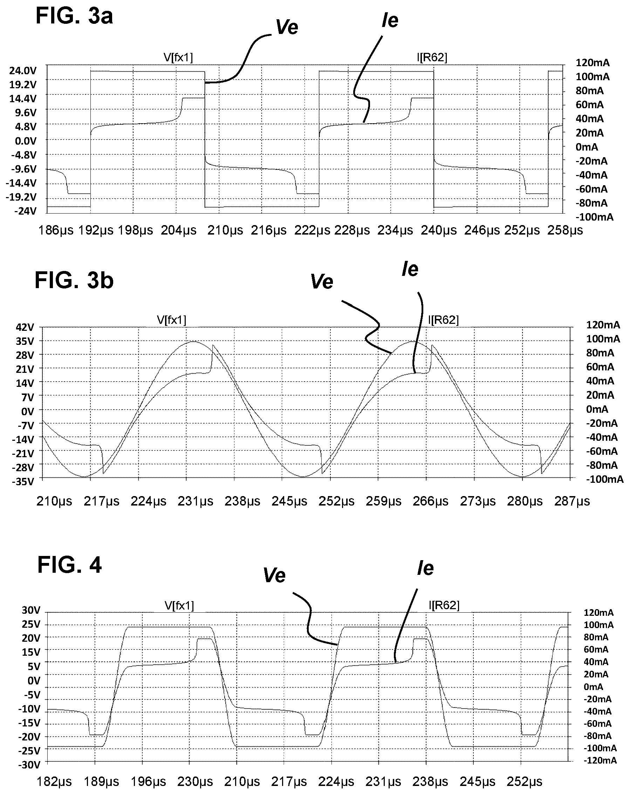

According to a second aspect of the invention, the shape of the excitation voltage signal for the excitation coil of the fluxgate magnetic field detector is provided as a trapezoidal shaped waveform Ve with rounded corners (figure 4). The aim is to reduce the high frequency content of the excitation current signal *Ie* compared to a voltage signal square wave (figure 3a), while obtaining a higher mean value of a signal half cycle compared to a sinusoidal signal of same peak value (figure 3b). This allows to saturate the fluxgate core using a lower peak voltage than would be required using a sinusoidal signal without however the drawbacks of using a square voltage that generates high frequency noise that adversely affects the output measurement signal. The FPGA comprises an excitation voltage control circuit portion 22 configured to generate an excitation voltage control signal for the excitation coil having a trapezoidal shaped waveform with rounded corners. The trapezoidal shaped waveform may be generated using a fluxgate excitation lookup table 29 stored in a memory of the FPGA or externally with an EPROM or flash memory.

### List of features

primary conductor 1
electrical current transducer 2
   **fluxgate measuring device 7**
      fluxgate magnetic field detector 4
         saturable soft magnetic core
         excitation coil
      secondary coil 6
      ripple compensation coil 26
   **control circuit 3**
      feedback loop 12
      compensation current drive circuit 13
      excitation coil drive circuit 14
         amplifier 20
      ripple compensation circuit 28
      **FPGA controller 18**
         1 bit sigma delta analog-to-digital converter (ADC) 21
            LVDS input 29a
         1 bit sigma delta digital-to-analog (DAC) outputs 27a, 27b, 27c, 27d
            RC filter 31a, 31b, 31c
primary current *I*_{P}
secondary current *I*_{S}
alternating excitation current *I*_{fx}
ripple cancellation current *I*_{R}

## Claims

1. Fluxgate current transducer (2) including a control circuit (3) and a fluxgate measuring device (7) comprising a fluxgate magnetic field detector (4), the fluxgate magnetic field detector comprising a saturable soft magnetic core surrounded by an excitation coil, the control circuit comprising an excitation coil drive circuit (14) connected to the excitation coil and a controller (18) connected to the excitation coil drive circuit configured to generate an alternating excitation current *I*_{fx} to alternatingly saturate the soft magnetic core, wherein the controller is in the form of a FPGA (Field Programmable Gate Array) comprising a plurality of LVDS (low voltage differential signaling) comparator inputs, each forming part of one of a plurality of 1 bit sigma delta analog-to-digital converters (ADC) (21) connected to the excitation coil to receive a measurement signal (19) output by the excitation coil, , wherein the bit stream output signals of said 1 bit sigma delta analog-to-digital converters (21) are added before being fed into a digital filter (32).

2. Current transducer according to the preceding claim wherein the 1 bit sigma delta analog-to-digital converter (ADC) comprises a first resistor (R1) connected in series to a first input (23) of the LVDS, a first capacitor (C1) connected between a reference potential and the first input, and a feedback loop from an output (25) of the LVDS and the first input, the feedback loop comprising a 1 bit DAC (27d) and second resistor (R2).

3. Current transducer according to any preceding claim wherein the FPGA comprises a 1 bit sigma delta digital-to-analog (DAC) output (27a) connected to the excitation coil via a RC filter (31a) to supply a voltage control signal that is fed into an amplifier (20) of the excitation coil drive circuit to supply the excitation coil of the fluxgate detector with an alternating excitation current.

4. Current transducer according to any preceding claim further comprising a compensation coil and the control circuit comprises a compensation coil drive circuit (13) to supply the compensation coil of the fluxgate measuring device with a compensation current *Is* seeking to cancel the magnetic field of the primary current *Ip,* the FPGA comprising a 1 bit sigma delta digital-to-analog (DAC) output (27b) connected to the compensation current coil via an RC filter (31b) to supply a voltage control signal to the compensation coil drive circuit.

5. Current transducer according to any preceding claim further comprising a ripple cancellation coil (26) and the control circuit comprises a ripple cancellation coil drive circuit (28) to supply the compensation coil of the fluxgate measuring device with a compensation current *Is* seeking to cancel the magnetic field of the primary current *Ip,* the FPGA comprising a 1 bit sigma delta digital-to-analog (DAC) output (27c) connected to the ripple current cancellation coil via an RC filter (31c) to supply a voltage control signal to the ripple cancellation coil drive circuit.

6. Current transducer according to any preceding claim wherein the FPGA comprises an excitation voltage control circuit portion (22) configured to generate an excitation voltage control signal Ve for the excitation coil having a trapezoidal shaped waveform with rounded corners.

7. Method of operating a fluxgate current transducer (2) according to any one of the preceding claims wherein the method includes generating an excitation signal for the excitation coil of the fluxgate magnetic field detector as a trapezoidal shaped waveform with rounded corners.

8. Method according to the preceding claim wherein the trapezoidal shaped waveform is generated using a fluxgate excitation lookup table (29) stored in a memory of the FPGA.

## Patentansprüche

1. Fluxgate-Stromwandler (2), der eine Steuerschaltung (3) und eine Fluxgate-Messvorrichtung (7) beinhaltet, die einen Fluxgate-Magnetfelddetektor (4) umfasst, wobei der Fluxgate-Magnetfelddetektor einen sättigbaren weichen Magnetkern umfasst, der von einer Erregerspule umgeben ist, wobei die Steuerschaltung eine Erregerspulenansteuerschaltung (14), die mit der Erregerspule verbunden ist, sowie eine Steuerung (18) umfasst, die mit der Erregerspulenansteuerschaltung verbunden und dazu ausgelegt ist, einen Erregerwechselstrom *I_{fx}* zu erzeugen, um den weichen Magnetkern alternierend zu sättigen, wobei die Steuerung die Form eines FPGA (feldprogrammierbares Gatearray) aufweist, das eine Vielzahl von Komparatoreingängen für eine Niederspannungsdifferenzialsignalisierung (LVDS), von denen jeder einen Teil einer Vielzahl von 1-Bit-Sigma-Delta-Analog-Digital-Wandlern (ADC) (21) ist, die mit der Erregerspule verbunden sind, um ein Messsignal (19) zu empfangen, das von der Erregerspule ausgegeben wird, wobei die Bitstromausgangssignale der 1-Bit-Sigma-Delta-Analog-Digital-Wandler (21) hinzugefügt werden, bevor sie zu einem digitalen Filter (32) geleitet werden.

2. Stromwandler nach dem vorhergehenden Anspruch, wobei der 1-Bit-Sigma-Delta-Analog-Digital-Wandler (ADC) einen ersten Widerstand (R1), der in Reihe mit einem ersten Eingang (23) des LVDS verbunden ist, einen ersten Kondensator (C1), der zwischen einem Referenzpotenzial und dem ersten Eingang verbunden ist, sowie eine Feedbackschleife von einem Ausgang (25) des LVDS und dem ersten Eingang umfasst, wobei die Feedbackschleife einen 1-Bit-DAC (27d) und einen zweiten Widerstand (R2) umfasst.

3. Stromwandler nach einem der vorhergehenden Ansprüche, wobei das FPGA einen 1-Bit-Sigma-Delta-Digital-Analog(DAC)-Ausgang (27a) umfasst, der über das RC-Filter (31a) mit der Erregerspule verbunden ist, um ein Spannungssteuersignal zuzuführen, dass in einen Verstärker (20) der Erregerspulenansteuerschaltung geleitet wird, um die Erregerspule des Fluxgate-Detektors mit einem Erregerwechselstrom zu versorgen.

4. Stromwandler nach einem der vorhergehenden Ansprüche, der ferner eine Kompensationsspule umfasst, wobei die Steuerschaltung eine Kompensationsspulenansteuerschaltung (13) umfasst, um die Kompensationsspule der Fluxgate-Messvorrichtung mit einem Kompensationsstrom *Is* zu versorgen, um das Magnetfeld des Primärstroms *Ip* aufzuheben, wobei das FPGA einen 1-Bit-Sigma-Delta-Digital-Analog(DAC)-Ausgang (27b) umfasst, der via ein RC-Filter (31b) mit der Kompensationsstromspule verbunden ist, um die Kompensationsspulenansteuerschaltung mit einem Spannungssteuersignal zu versorgen.

5. Stromwandler nach einem der vorhergehenden Ansprüche, der ferner eine Welligkeitsaufhebungsspule (26) und die Steuerschaltung eine Welligkeitsaufhebungsspulenansteuerschaltung (28) umfasst, um die Kompensationsspule der Fluxgate-Messvorrichtung mit einem Kompensationsstrom *Is* zu versorgen, um das Magnetfeld des Primärstroms *Ip* aufzuheben, wobei das FPGA einen 1-Bit-Sigma-Delta-Digital-Analog(DAC)-Ausgang (27c) umfasst, der via ein RC-Filter (31c) mit der Welligkeitsaufhebungsspule verbunden ist, um die Welligkeitsaufhebungsspulenansteuerschaltung mit einem Spannungssteuersignal zu versorgen.

6. Stromwandler nach einem der vorhergehenden Ansprüche, wobei das FPGA einen Erregungsspannungssteuerschaltungsabschnitt (22) umfasst, der dazu ausgelegt ist, ein Erregungsspannungssteuersignal *Ve* für die Erregerspule zu erzeugen, und eine Trapezwellenform mit abgerundeten Ecken aufweist.

7. Verfahren zum Betreiben eines Fluxgate-Stromwandlers (2) nach einem der vorhergehenden Ansprüche, wobei das Verfahren das Erzeugen eines Erregungssignals für die Erregerspule des Fluxgate-Magnetfelddetektors als eine Trapezwellenform mit abgerundeten Ecken beinhaltet.

8. Verfahren nach dem vorhergehenden Anspruch, wobei die Trapezwellenform unter Verwendung einer Fluxgate-Erregernachschlagetabelle (29) erzeugt wird, die in einem Speicher des FPGA gespeichert ist.

## Revendications

1. Transducteur de courant fluxgate (2) comportant un circuit de commande (3) et un dispositif de mesure fluxgate (7) comprenant un détecteur de champ magnétique fluxgate (4), le détecteur de champ magnétique fluxgate comprenant un noyau magnétique doux saturable entouré d'une bobine d'excitation, le circuit de commande comprenant un circuit d'attaque de bobine d'excitation (14) connecté à la bobine d'excitation et un contrôleur (18) connecté au circuit d'attaque de bobine d'excitation configuré pour générer un courant d'excitation alternatif *I*_{fx} afin de saturer de manière alternative le noyau magnétique doux, dans lequel
le contrôleur se présente sous la forme d'un FPGA (réseau de portes programmables) comprenant une pluralité d'entrées de comparateur LVDS (signalisation différentielle à basse tension), chacune faisant partie de l'un d'une pluralité de convertisseurs analogique-numérique (ADC) sigma-delta à 1 bit (21) connectés à la bobine d'excitation pour recevoir un signal de mesure (19) émis par la bobine d'excitation, dans lequel les signaux de sortie de train de bits desdits convertisseurs analogique-numérique sigma-delta à 1 bit (21) sont additionnés avant d'être introduits dans un filtre numérique (32).

2. Transducteur de courant selon la revendication précédente, dans lequel le convertisseur analogique-numérique (ADC) sigma-delta à 1 bit comprend une première résistance (R1) connectée en série à une première entrée (23) de la LVDS, un premier condensateur (C1) connecté entre un potentiel de référence et la première entrée, et une boucle de rétroaction d'une sortie (25) de la LVDS et de la première entrée, la boucle de rétroaction comprenant un DAC à 1 bit (27d) et une deuxième résistance (R2).

3. Transducteur de courant selon l'une des revendications précédentes, dans lequel le FPGA comprend une sortie de convertisseur numérique-analogique (DAC) sigma-delta à 1 bit (27a) connectée à la bobine d'excitation via un filtre RC (31a) destinée à fournir un signal de commande de tension qui est introduit dans un amplificateur (20) du circuit d'attaque de bobine d'excitation pour alimenter la bobine d'excitation du détecteur fluxgate avec un courant d'excitation alternatif.

4. Transducteur de courant selon l'une des revendications précédentes, comprenant en outre une bobine de compensation, et le circuit de commande comprend un circuit d'attaque de bobine de compensation (13) destiné à fournir à la bobine de compensation du dispositif de mesure fluxgate un courant de compensation *Is* visant à annuler le champ magnétique du courant primaire *Ip*, le FPGA comprenant une sortie de convertisseur numérique-analogique (DAC) sigma-delta à 1 bit (27b) connectée à la bobine de courant de compensation via un filtre RC (31b) destinée à fournir un signal de commande de tension au circuit d'attaque de bobine de compensation.

5. Transducteur de courant selon l'une des revendications précédentes, comprenant en outre une bobine d'annulation d'ondulation (26), et le circuit de commande comprend un circuit d'attaque de bobine d'annulation d'ondulation (28) destiné à fournir à la bobine de compensation du dispositif de mesure fluxgate un courant de compensation *Is* visant à annuler le champ magnétique du courant primaire *Ip*, le FPGA comprenant une sortie de convertisseur numérique-analogique (DAC) sigma-delta à 1 bit (27c) connectée à la bobine d'annulation de courant d'ondulation via un filtre RC (31c) destinée à fournir un signal de commande de tension au circuit d'attaque de bobine d'annulation d'ondulation.

6. Transducteur de courant selon l'une des revendications précédentes, dans lequel le FPGA comprend une partie de circuit de commande de tension d'excitation (22) configurée pour générer un signal de commande de tension d'excitation *Ve* pour la bobine d'excitation présentant une forme d'onde trapézoïdale aux angles arrondis.

7. Procédé de fonctionnement d'un transducteur de courant fluxgate (2) selon l'une des revendications précédentes, dans lequel le procédé comprend la génération d'un signal d'excitation pour la bobine d'excitation du détecteur de champ magnétique fluxgate dans une forme d'onde trapézoïdale aux angles arrondis.

8. Procédé selon la revendication précédente, dans lequel la forme d'onde trapézoïdale est générée à l'aide d'une table de consultation d'excitation fluxgate (29) stockée dans une mémoire du FPGA.
